# FASCICULE DE BREVET EUROPEEN

(11) **EP 2 432 034 B1**
(45) Date de publication et mention de la délivrance du brevet: **09.08.2017**
(21) Numéro de dépôt: 11306126.1
(22) Date de dépôt: 12.09.2011
(51) Int. Cl.: H01L 31/101, H01L 31/18, H01L 27/146

(54) **Détecteur bispectral multicouche à photodiodes et procédé de fabrication d'un tel détecteur**
Bispektraler mehrschichtiger Detektor mit Fotodioden, und Herstellungsverfahren für einen solchen Detektor
Multi-layer bispectral detector with photodiodes and method for manufacturing such a detector

(30) Priorité: 16.09.2010 FR 1057390
(43) Date de publication de la demande: 21.03.2012
(73) Titulaire: COMMISSARIAT À L'ÉNERGIE ATOMIQUE ET AUX ÉNERGIES ALTERNATIVES, 75015 Paris (FR)
(72) Inventeur: Gravrand, Olivier, 38120 FONTANIL CORNILLON (FR); Baylet, Jacques, 38100 GRENOBLE (FR)
(74) Mandataire: Cabinet Laurent & Charras

(56) Documents cités:
- WO-A2-2005/101512
- FR-A1- 2 812 454
- FR-A1- 2 849 273
- US-A- 6 034 407

## Description

### DOMAINE DE L'INVENTION

L'invention a trait au domaine de la détection bi-spectrale au moyen de deux couches d'absorption d'un même empilement, et dans lesquelles sont formées des jonctions PN.

### ETAT DE LA TECHNIQUE

Un détecteur bispectral privilégié en raison de son taux de remplissage élevé et de sa cohérence temporelle comprend un empilement de plusieurs couches semi-conductrices d'absorption de différentes gammes de fréquences de rayonnements électromagnétiques, isolées les unes des autres, et dans lesquels sont formées des jonctions PN pour la collecte des porteurs de charge créés par l'absorption d'un rayonnement incident. Un tel détecteur est par exemple décrit dans les documents US 6 034 407 et « Status of HgCdTe bicolor and dual-band infrared array at LETI » de Destefanis, Journal of Electronic Materials 36(8), p.1031, (2007). Ces deux premières références concernent le matériau CdHgTe. Un exemple de structure similaire utilisant un autre matériau peut être consulté dans le document : Kim, "A Three Wavelength Infrared Focal Plane Array Detector Element", IEEEPhotonicsTechLett 6(2) p235 (1994).

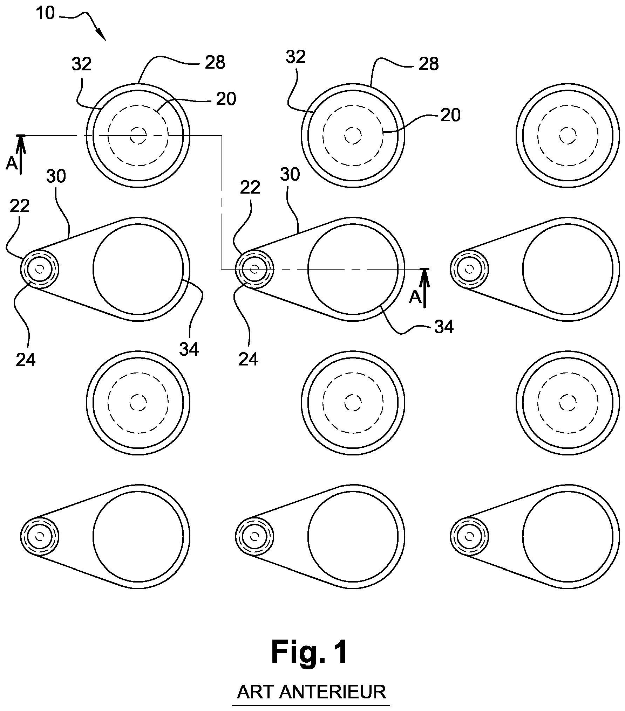

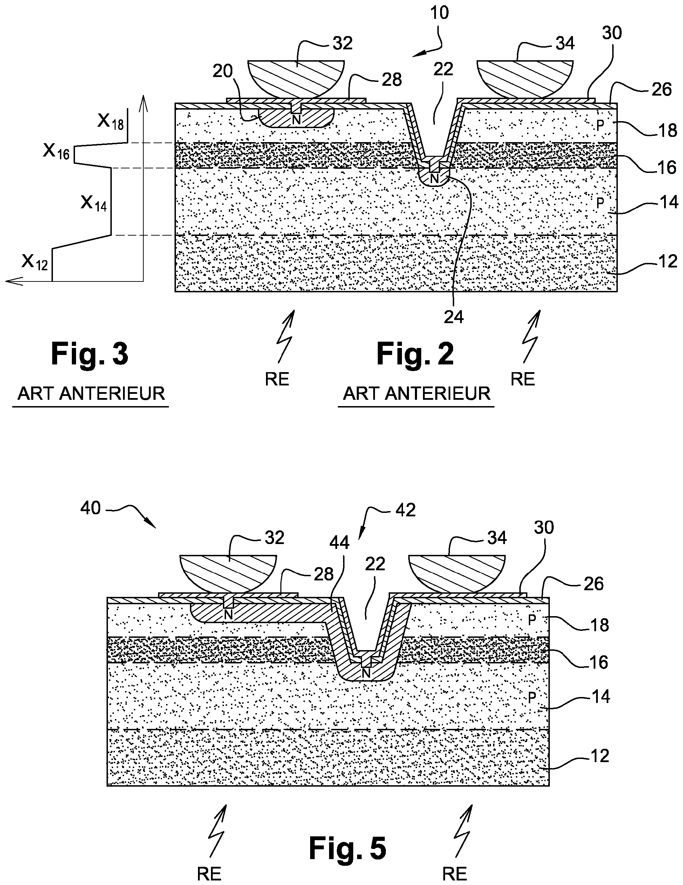

Afin de comprendre les problèmes survenant dans ce type de détecteur, il va à présent être décrit, en relation avec les figures 1 à 3, un exemple de détecteur matriciel bispectral **10.** La figure 1 est une vue de dessus de ce détecteur, représenté ici sous la forme d'un détecteur bidimensionnel de deux pixels par trois pixels, la figure 2 est une vue en coupe selon l'axe A-A représenté à la figure 1, et la figure 3 est un profil de composition x en cadmium des différents alliages de cadmium, de mercure et de tellure (CdₓHg₁₋ₓTe) formant l'empilement du détecteur.

Le détecteur **10** comprend un empilement formé :
▪ d'un substrat **12,** constitué d'un alliage de cadmium, de zinc et de tellure, ou alliage «CZT»;
▪ d'une couche **14** inférieure d'absorption semi-conductrice de type P, formée sur le substrat **12.** La couche **14** est constituée d'un alliage CdₓHg₁₋ₓTe, dopé P par lacunes de mercure et de faible gap. La composition *x₁₄* en cadmium de la couche **14** est choisie pour que celle-ci soit absorbante dans une première gamme de longueurs d'onde autour d'une longueur d'onde *λ*₁₄;
▪ d'une couche **16** intermédiaire, formant barrière réalisée sur la couche inférieure **14.** La couche **16** est constitué d'un matériau de grand gap, par exemple un alliage CdₓHg₁₋ₓTe dont la composition *x₁₆* est importante au regard de la composition en cadmium *x₁₄*, *x₁₈* des couches **14** et **18 ;** et
▪ d'une couche **18** supérieure d'absorption semi-conductrice de type P, formée sur la couche **16** formant barrière. La couche **18** est constituée d'un alliage CdₓHg₁₋ₓTe, dopée P par lacunes de mercure et de faible gap. La composition *x₁₈* en cadmium de la couche **18** est choisie pour que celle-ci soit absorbante dans une deuxième gamme de longueurs d'onde autour d'une longueur d'onde *λ*₁₈ que λ₁₈<λ₁₄

Des zones semi-conductrices de type N **20** sont par ailleurs réalisées dans la couche supérieure **18,** par implantation ionique de bore, par exemple. Cette étape d'implantation ionique a pour effet une conversion du dopage intrinsèque de type P en type N et forme ainsi une matrice de jonctions PN, et donc des photodiodes.
Des évidements **22** sont en outre usinés au travers de la couche supérieure **18** et de la couche intermédiaire **16** jusqu'à la couche inférieure **14** afin d'avoir accès à celle-ci. Des zones semi-conductrices de type N **24** sont réalisées dans la couche inférieure **14** en appliquant un dopage N par implantation ionique de Bore, par exemple, aux parties de la couche inférieure **14** affleurant sur le fond des évidements **22.** Une matrice de jonctions PN, et donc de photodiodes, est ainsi formée dans la couche inférieure **14.**
De préférence, les zones semi-conductrices **20** et les zones semi-conductrices **24** forment respectivement des matrices de détection de *L* lignes par *C* colonnes, avec *L* et *C* égaux respectivement à 2 et 3 dans l'exemple illustré, et la matrice de zones **24** est décalée par rapport à la matrice de zones **20** de manière à avoir une zone **24** au centre d'un rectangle ou d'un carré constitué de quatre zones 20. Une couche de passivation **26** (non représentée sur la figure 1 pour des raisons de clarté des dessins) réalisée à l'aide d'un bicouche CdTe/ZnS est en outre déposée sur la face libre de la couche supérieure **18** et dans les évidements **22.**
Enfin, une reprise de contact métallique **28** est formée sur la couche supérieure **18** au dessus de chaque zone **20** et pénètre la zone **20** pour la collecte des charges contenues dans celle-ci. De même, une reprise de contact métallique **30** est déposée dans chaque évidement **22** sous forme d'une couche recouvrant les flancs de l'évidement et pénètre dans la zone **24** correspondante pour la collecte des charges contenues dans cette zone. La reprise de contact **30** se prolonge sur la face supérieure de la couche de passivation **26** pour faciliter la connexion de la reprise **30** à une connectique externe (non représentée). Enfin, une bille d'indium **32, 34** est réalisée sur la partie de chaque reprise de contact **28, 30** formée sur la face supérieure de la couche de passivation **26** pour l'hybridation de l'empilement sur un circuit de lecture (non représenté) par la technique dite de « *flip chip* ».

Le détecteur **10** venant d'être décrit est un détecteur à illumination arrière (« *backside illuminated sensor* »). La face libre du substrat **12** reçoit un rayonnement électromagnétique *RE* qui pénètre l'empilement. La portion du rayonnement *RE,* comprise dans la première gamme de longueurs d'onde, est absorbée par la couche inférieure **14,** et la portion du rayonnement *RE,* comprise dans la deuxième gamme de longueur d'onde, est absorbée par la couche supérieure **18.**

Comme cela est connu en soi, l'absorption de photons dans les couches inférieure **14** et supérieure **18** libère des porteurs de charge qui diffusent jusqu'aux zones semi-conductrices **20, 24,** et qui sont collectés par les reprises de contact **28, 30.** Une polarisation est ou non appliquée entre un contact commun périphérique (non représenté sur la figure 2) et les reprises de contact **28, 30** d'une manière connue en soi.

Le rôle de la couche intermédiaire **16** est d'empêcher que des porteurs de charge, créés dans l'une des couches **14, 18,** ne diffusent dans l'autre couche **14, 18,** provoquant ainsi un phénomène de diaphonie, ou « *cross-talk* », nuisible à la qualité de la détection. Cette fonction est plus communément désignée sous l'expression de fonction « barrière ».

La qualité de la fonction barrière de la couche intermédiaire **16** dépend principalement de la différence existant entre la valeur de la bande interdite, ou « *gap* », de la couche intermédiaire **16,** et, d'une part, celle de la couche inférieure **14,** et, d'autre part, celle de la couche supérieure **18.** La couche intermédiaire **16** forme ainsi une barrière de potentiel séparant les bandes de valence et de conduction des couches inférieure **14** et supérieure **18,** limitant donc le passage des porteurs de charge d'une couche à l'autre.

Dans un alliage semi-conducteur du type CdₓHg₁₋ₓTe, la valeur du gap est déterminée principalement par la composition (*1-x)* en mercure, ou de manière équivalente par la composition en cadmium *x.* La figure 3 illustre un profil typique des compositions x en cadmium des différentes couches de l'empilement avec une composition *x₁₆* de la couche intermédiaire **16,** préférentiellement d'au moins 50%, à chacune des compositions *x₁₄*, *x₁₈* des couches inférieure **14** et supérieure **18.**

Les évidements **22** sont nécessaires pour accéder à la couche inférieure **14,** et ainsi permettre la réalisation des zones semi-conductrices **24,** mais également pour pouvoir réaliser les reprises de contact **30** pour la collecte des charges des zones **24.**

Or, quelle que soit la technique d'usinage utilisée pour former les évidements **22,** les parois de ceux-ci présentent de nombreuses imperfections. La qualité cristalline des flancs du trou peut être dégradée par la gravure avec pour conséquence une vitesse de recombinaison élevée sur la surface. De fait, les parties des évidements **22** présentes dans la couche supérieure **18** sont des sources de recombinaison pour les porteurs de charge de celle-ci, ainsi que des sources de bruit basse fréquence associé à ce courant de génération pour les jonctions PN de cette couche **18.**

Une solution usuellement retenue pour palier ce problème est d'éloigner les jonctions PN de la couche supérieure **18** des évidements **22.** Le taux de remplissage du pixel (ou « *fill factor* ») est donc diminué.

Une autre solution consiste également à utiliser des techniques d'usinage des évidements **22** par plasma et de réparation des flancs des évidements par recuit. Cette solution serait idéalement préférable, mais demande un parfait contrôle du procédé de gravure, ce qui requière un développement technologique lourd.

### EXPOSE DE L'INVENTION

Le but de l'invention est de résoudre le problème posé par les imperfections des évidements en proposant un détecteur et un procédé de fabrication de détecteur, dans lesquels les parties d'évidement comprises dans la couche supérieure sont rendues électriquement invisibles pour cette couche, alors même que ces imperfections peuvent être toujours présentes.

A cet effet, l'invention a pour objet un détecteur bispectral d'une première et seconde gammes de rayonnements électromagnétiques, comportant :
▪ un empilement de couches semi-conductrices supérieure et inférieure d'un premier type de conductivité pour l'absorption des première et seconde gammes de rayonnements électromagnétiques respectivement, séparées par une couche intermédiaire formant barrière de potentiel entre les couches supérieure et inférieure ;
▪ des zones semi-conductrices d'un second type de conductivité opposé au premier type, implantées dans les couches supérieure et inférieure, chaque zone semi-conductrice dans la couche inférieure étant implantée au moins partiellement dans le fond d'un évidement traversant les couches supérieure et intermédiaire; et
▪ des éléments conducteurs d'électricité connectés respectivement aux zones semi-conductrices pour la collecte de charges électriques dans celles-ci.

Selon l'invention, au moins la partie de chaque évidement, traversant la couche supérieure, est séparée de cette dernière par une couche écran semi-conductrice du second type de conductivité :
▪ dont la concentration en dopants du second type de conductivité est supérieure à 10¹⁷ cm⁻³; et
▪ dont l'épaisseur est choisie en fonction de ladite concentration de manière à être supérieure à la longueur de diffusion des porteurs minoritaires dans la couche écran.

En effet, les porteurs générés par ladite surface visitent le matériau autour d'eux par diffusion avant de se recombiner. La longueur de diffusion est alors définie par la distance moyenne parcourue par un porteur minoritaire durant sa durée de vie. Cette longueur de diffusion diminuant rapidement avec le dopage (on obtient classiquement une fraction de micromètre pour un dopage de 10¹⁷ cm⁻³)_{.}

En d'autres termes, plus la concentration en dopants du second type, par exemple N, implantés dans un matériau du premier type, par exemple P, est importante, plus la longueur de diffusion des porteurs de charge dans ledit matériau dopée N est courte.

En choisissant par ailleurs une épaisseur appropriée pour la couche écran, par exemple de l'ordre de trois fois la longueur de diffusion des porteurs de charge, lesdits porteurs de charge ne sont donc pas en mesure d'atteindre les flancs des évidements, et donc de se recombiner sur les imperfections de ces flancs. Inversement, les porteurs de charge générés par les flancs ne peuvent ensuite pas diffuser jusqu'à la jonction pour contribuer au courant d'obscurité et au bruit de la photodiode.

Ainsi, une couche de passivation en alliage CdₓHg₁₋ₓTe, qui est initialement de type P grâce à des lacunes de mercure et qui a ensuite subie une conversion de dopage en type N d'une concentration supérieure à 10¹⁷, par implantation ionique de bore par exemple, et qui présente en outre une épaisseur supérieure à 500 nanomètres, masque efficacement les évidements. Cette épaisseur peut être choisie de l'ordre de la centaine de nanomètres lorsque la concentration en dopant N est supérieure ou égale à 10¹⁸.

Les évidements sont donc masqués électriquement pour les porteurs de charge de la couche supérieure. Les sources de recombinaison de porteurs de charge et de bruit constituées par les évidements ont donc ainsi été fortement atténuées, voire ont disparu. De plus, selon l'invention:
▪ chaque zone semi-conductrices de la couche supérieure forme avec une zone semi-conductrice adjacente de la couche inférieure un volume continu ; et
▪ la couche intermédiaire est en un matériau isolant relativement aux matériaux des couches supérieure et inférieure, ou en un matériau semi-conducteur du premier type de conductivité dont la bande interdite est supérieure à trois fois celle de chacune des couches inférieure et supérieure.
En d'autres termes, en réalisant des zones semi-conductrices de cette manière, un taux de remplissage optimal de photodiodes est atteint puisqu'il est possible de positionner les jonctions PN de la couche supérieure au plus près des évidements. En outre, le choix de la couche intermédiaire limite le phénomène de diaphonie.
De préférence :
▪ les couches supérieure et inférieure sont réalisées en un alliage de cadmium, de mercure et de tellure, dopées P par lacunes de mercure ;
▪ et la couche intermédiaire est réalisée en un alliage de cadmium et de tellure ou en un alliage de cadmium, de zinc et de tellure.
En d'autres termes, une fonction barrière quasi parfaite est mise en oeuvre par la couche intermédiaire car elle est isolante vis-à-vis des couches supérieure et inférieure.
En variante :
▪ les couches supérieure et inférieure sont réalisées en un alliage de cadmium, de mercure et de tellure, dopées P par lacunes de mercure ;
▪ et la couche intermédiaire est réalisée un alliage de cadmium, de mercure et de tellure, dont la composition en mercure est inférieure à la moitié la composition en mercure dans chacune des couches supérieure et inférieure.
En d'autres termes, la couche intermédiaire comprend une composition minime en mercure de manière à faciliter la construction de l'empilement. Par exemple, la croissance de l'empilement est réalisée au moyen d'une épitaxie par jet moléculaire sur le substrat. Parallèlement, la couche intermédiaire assure une fonction barrière de grande qualité liée à la valeur élevée de son gap induite par une faible composition en mercure. En effet, dans le cas du CdHgTe, une interface entre deux compositions différentes créée une barrière de potentiel sur la bande de valence bloquant ainsi les porteurs minoritaires du matériau P.

Selon l'invention, la partie de chaque évidement traversant la couche intermédiaire est séparée de cette dernière par une couche écran semi-conductrice du second type de conductivité.

Selon un mode de réalisation, la couche intermédiaire est réalisée en un matériau isolant relativement au matériau des couches supérieure et inférieure ou en matériau semi-conducteur du premier type de conductivité dont la bande interdite est supérieure à trois fois celle de chacune des couches supérieure et inférieure.
L'invention a également pour objet un procédé de fabrication d'un détecteur bispectral tel que défini dans la revendication 6. Selon l'invention, un dopage du second type de conductivité par implantation ionique ou usinage ionique est réalisé sur les flans de chaque évidement, au moins sur la partie desdits flancs agencée dans la couche supérieure.
Pour plus de détails, on se référera à la publication de G. Destefanis, « Electrical doping of HgCdTe by ion implantation and heat treatment », Journal of Crystal Growth 86 p700 (1988).

En d'autres termes, on a observé que ces techniques de dopage forment à la surface des éléments auxquels elles sont appliqués une couche de forte concentration de dopant N, ou couche dite « N+ », supérieure à 10¹⁷ cm⁻³, et ceci sur une épaisseur suffisante pour masquer électriquement les évidements.
Ainsi, l'application de ces techniques de dopage à un matériau CdₓHg₁₋ₓTe, de type P en raison de ses lacunes de mercure, crée une couche N+ d'environ 100 nanomètres avec une concentration en dopant N d'environ 10¹⁸ cm⁻³, ce qui suffit amplement à masquer efficacement les évidements.

Selon l'invention,
▪ la couche intermédiaire est réalisée en un matériau isolant relativement aux matériaux des couches supérieure et inférieure, en un matériau semi-conducteur du premier type de conductivité dont la bande interdite est choisie au moins trois fois supérieure à celle de chacune des couches supérieure et inférieure;
▪ et le dopage du second type de conductivité est appliqué sur la totalité des évidements, de sorte que, dans le fond de ceux-ci, les zones semi-conductrices de second type sont formées dans la couche inférieure.
En d'autres termes, la couche écran selon l'invention est réalisée par la technique utilisée pour former les zones semi-conductrices du second type de conductivité. En effet, l'implantation ionique et l'usinage ionique forment naturellement un empilement d'une couche N+ de forte concentration en dopant, et d'une couche N de plus faible concentration en dopants. Il est également remarquable qu'une couche écran masquant électriquement les évidements peut être réalisée conjointement avec les zones semi-conductrices de second type de conductivité des couches inférieures, et donc en une seule étape de procédé. Par exemple, une seule étape d'implantation ionique est réalisée à l'aide d'un masquage approprié de l'empilement.

Selon une variante de l'invention, le dopage du second type de conductivité sur les flancs des évidements se prolonge sur la face libre de la couche supérieure, de sorte que les zones semi-conductrices du second type sont formées dans celle-ci.

Le taux de remplissage des photodiodes est ainsi optimal. En outre, les zones semi-conductrices de la couche supérieure, ainsi que les couches de masquage électrique des évidements sont réalisées en une seule étape, par exemple par application d'un masquage approprié lors d'une implantation ionique.

Selon une autre variante de l'invention, les zones semi-conductrices de second type dans la couche supérieure sont réalisées de manière à ne pas être en contact avec les zones semi-conductrices du second type obtenues à l'issue du dopage des flancs des évidements. Notamment, il est également formé, dans la couche supérieure, des éléments semi-conducteurs du second type, notamment par implantation ionique ou usinage ionique, raccordant des zones semi-conductrices du second type obtenues à l'issue du dopage des flancs des évidements à un élément conducteur commun.

En d'autres termes, on évite ainsi un pincement des zones semi-conductrices du second type de la couche supérieure en raison de la présence des évidements. Le courant d'obscurité est ainsi limité. En outre, la formation des éléments semi-conducteurs permet de mettre l'ensemble des zones semi-conductrices des évidements au même potentiel.

Selon un mode de réalisation de l'invention,
▪ les couches supérieure et inférieure sont réalisées en un alliage de cadmium, de mercure et de tellure, dopées P par lacunes de mercure ;
▪ et la couche intermédiaire est réalisée en un alliage de cadmium et de tellure ou en un alliage de cadmium, de zinc et de tellure.

Selon un autre mode de réalisation,
▪ les couches supérieure et inférieure sont réalisées en un alliage de cadmium, de mercure et de tellure, dopées P par lacunes de mercure ;
▪ et la couche intermédiaire est réalisée en un alliage de cadmium, de mercure et de tellure, dont la composition en mercure est inférieure à la moitié de la composition en mercure dans chacune des couches supérieure et inférieure.

### BREVE DESCRIPTION DES FIGURES

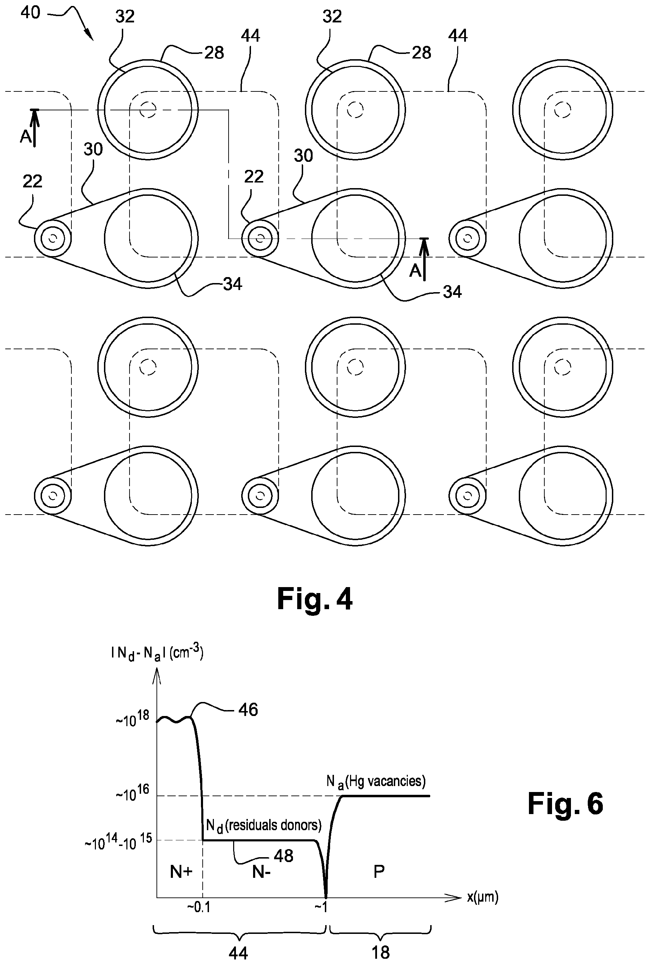

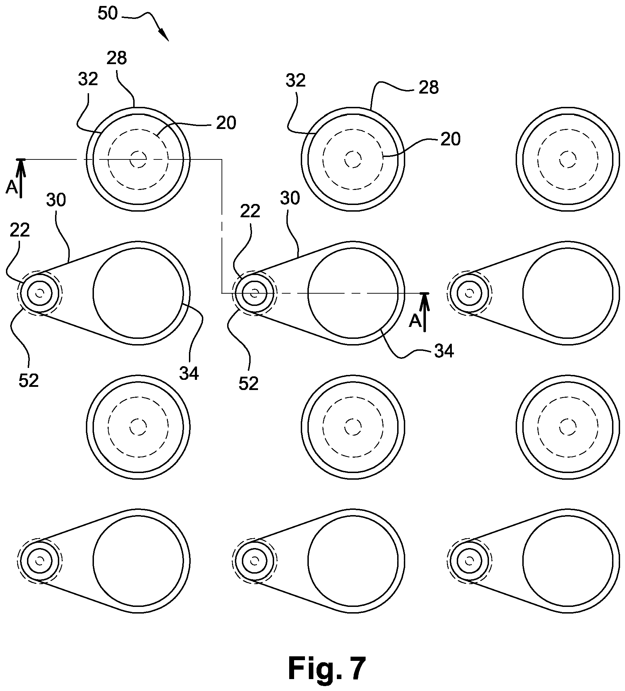

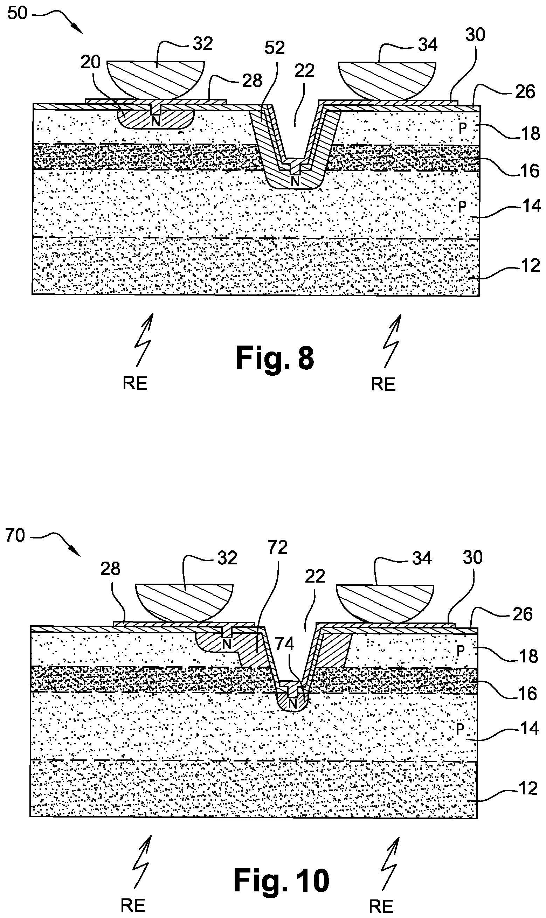

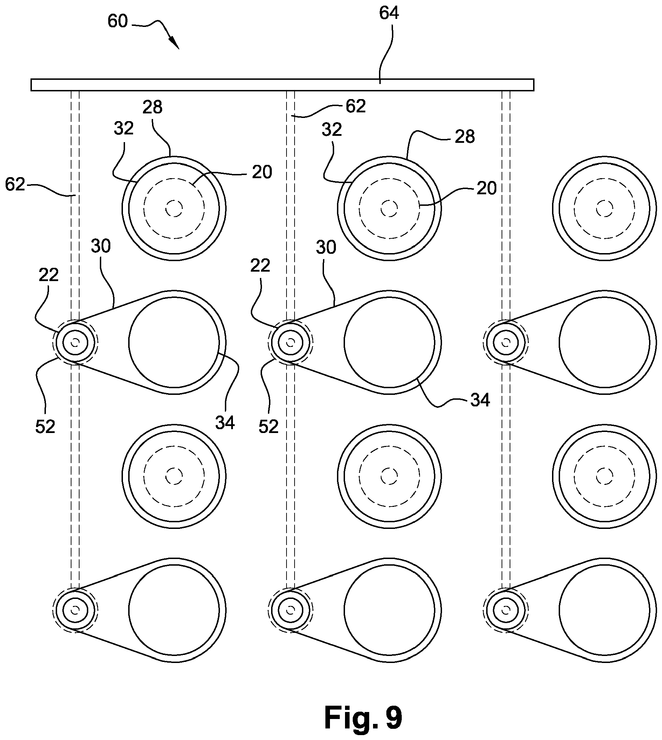

L'invention sera mieux comprise à la lecture de la description qui va suivre, donnée uniquement à titre d'exemple, et réalisée en relation avec les dessins annexés, dans lesquels des références identiques désignent des éléments identiques ou fonctionnellement analogues, et dans lesquels :
▪ les figures 1 et 2 sont des vues de dessus et en coupe d'un détecteur matriciel, tel que déjà décrit dans le préambule ;
▪ la figure 3 est un profil de composition en cadmium des couches de l'empilement du détecteur des figures 1 et 2, tel que déjà décrit dans le préambule ;
▪ les figures 4 et 5 sont des vues de dessus et en coupe d'un détecteur matriciel selon un premier mode de réalisation de l'invention ;
▪ la figure 6 est un profil de concentration en donneurs de charge dans l'empilement à l'issue d'une implantation ionique ;
▪ les figures 7 et 8 sont des vues de dessus et en coupe d'un détecteur matriciel ne faisant pas partie de l'invention ;
▪ la figures 9 est une vue de dessus d'un détecteur matriciel ne faisant pas partie de l'invention ; et
▪ la figure 10 est une vue en coupe d'un détecteur matriciel ne faisant pas partie de l'invention.

### DESCRIPTION DETAILLEE DE L'INVENTION

### MODE DE REALISATION

Il va à présent être décrit un détecteur 40 selon un premier mode de réalisation de l'invention en relation avec les figures 5 et 6. Le détecteur **40** diffère du détecteur **10** des figures 1 à 3 par la forme des zones semi-conductrices de type N, ou « zones N », implantées dans les couches **14, 16, 18** de l'empilement.
Plus particulièrement, après dépôt de la couche de passivation **26,** un dopage de type N, est réalisé par implantation ionique de bore, par exemple, sur des portions de la face supérieure **42** de l'empilement à travers la couche de passivation **26.**
Cette implantation ionique est de préférence réalisée à l'aide d'un masque approprié, apposé sur la face supérieure **42** et masquant cette dernière, sauf en ce qui concerne les portions à implanter. Les couches **12, 14, 16,** les évidements **22,** les reprises de contacts **28, 30** et les connectiques **32, 34** sont quant à eux par exemple réalisés selon le procédé décrit dans le document « Status of HgCdTe bicolor and dual-band infrared array at LETI » de Destefanis, JEM 36(8), p.1031, 2007.

Chacune des portions implantées comprend un évidement **22** et se prolonge sur une partie de la couche supérieure **18** au dessus de laquelle est formée la reprise de contact métallique **28,** comme cela est illustré à la figure 4. Des volumes spatialement continus **44** de zones N sont ainsi obtenus. Chacun de ces volumes **44** englobe donc un évidement **22,** et constitue à la fois une zone N pour la formation d'une jonction PN dans la couche supérieure **18** et une zone N, implantée au fond de l'évidement **22,** pour la formation d'une jonction PN dans la couche inférieure **14.**

La figure 6 illustre le profil spatial de la concentration en donneurs de charge ainsi obtenu par l'implantation ionique. Ce profil est pris selon un axe quelconque perpendiculaire à la paroi d'un évidement **22** comprise dans la couche supérieure **18,** et comprend la concentration en donneurs de charge dans un volume **44,** ainsi que la concentration en donneurs de charge dans la couche supérieure **18.** Les concentrations sont ici tracées en fonction de l'épaisseur selon l'axe considéré.

Comme on peut le noter, un volume **44** se partage essentiellement en une première couche « N+ » **46,** d'une épaisseur d'environ 100 nanomètres et d'une concentration en dopants N environ égale à 10¹⁸, et en une deuxième couche « N- » **48,** de plusieurs centaines de nanomètres d'épaisseur, par exemple 900 nm, et d'une concentration moindre en dopant N. On montre que la couche **46** est suffisante pour masquer électriquement les parois des évidements **22** aux porteurs de charge compris dans la couche supérieure **18.**

Un tel profil se retrouve sensiblement dans tout le volume **44,** seule la partie « P » variant en fonction de la couche supérieure **18,** inférieure **14** ou intermédiaire **16.** La couche notée « N- » dans le profil forme une jonction PN avec la zone noté « P » adjacente de la couche supérieure ou inférieure.

Il est également remarquable que le taux de remplissage des photodiodes créées par l'implantation de zones semi-conductrices N dans les couches P supérieure et inférieure est optimal. En effet, il n'est nullement besoin de prévoir une distance minimale entre les jonctions PN de la couche supérieure et les évidements **22** puisque ces derniers sont électriquement masqués.

On notera également que des zones N peuvent traverser la couche intermédiaire **16** en raison de l'implantation ionique qui est réalisée sur l'intégralité des flancs des évidements **22.** Si l'on n'y prend garde, les zones N ainsi constituées peuvent permettre à des porteurs de charge de transiter entre les couches supérieure **18** et inférieure **14,** au travers de la couche intermédiaire **16.** Un phénomène de diaphonie peut ainsi apparaître.

Pour pallier ceci, la couche intermédiaire **16** aurait pu être choisie pour que l'implantation ionique effectuée sur les flancs des évidements **22** ne crée pas de zones N dans la couche intermédiaire **16.**

Ainsi, lorsque les couches supérieure et inférieure sont réalisées en alliage CdₓHg₁₋ₓTe, de type P au moyen d'un dopage par lacunes de mercure, la couche intermédiaire **16** aurait pu être constituée d'un alliage de cadmium et de tellure ou d'un alliage de cadmium, de zinc et de tellure. Non seulement, un tel alliage est isolant vis-à-vis des alliages en CdₓHg₁₋ₓTe de type P, et réaliserait une fonction barrière de grande qualité, mais en outre l'implantation ionique ne créerait pas dans la couche intermédiaire **16** de zone N puisque le processus d'inversion de dopage se produit uniquement grâce à la présence de mercure dans l'alliage. Comme il n'existerait pas de continuité des zones N entre les couches supérieure et inférieure, les porteurs de charge ne pourraient donc pas transiter entre ces couches via la couche intermédiaire. Le phénomène de diaphonie serait donc évité.
Toutefois de tels alliages compliquent le procédé de fabrication de l'empilement. En effet, la technique utilisé pour former la couche supérieure **18** dépend de la nature du support sur laquelle elle est réalisée, et donc ici de la couche intermédiaire **16.** Ainsi par exemple, les alliages précités ne sont pas les mieux appropriés pour favoriser la croissance de la couche supérieure **16** au moyen d'une épitaxie par jet moléculaire, ou « *EJM* »*,* qui est usuellement la technique privilégiée pour réaliser des couches en alliage CdₓHg₁₋ₓTe.
Pour favoriser la croissance de la couche supérieure **18** sur la couche intermédiaire **16,** il est ainsi préférable d'ajouter une quantité minime de mercure, et ainsi réaliser cette couche en alliage de CdHgTe. Or, la présence de mercure dans la couche intermédiaire **16** a pour effet que l'implantation ionique ultérieure des flancs des évidements **22** forme dans la couche **16** des zones N, et donc un passage possible pour les porteurs de charge entre les couches supérieure **18** et inférieure **16.**

Pour éviter qu'un phénomène de diaphonie n'apparaisse, la composition en mercure de la couche **16** est limitée. Plus particulièrement, la composition en cadmium de cette couche est supérieure au double de chacune des compositions en cadmium des couches supérieure **18** et inférieure **14.** De cette manière, en présence d'une différence de polarisation limitée entre les zones N de la couche supérieure et les zones N de la couche inférieure, il existe une isolation électrique de qualité suffisante entre ces couches, liée à la formation d'une barrière de potentiel sur les bandes du semi-conducteur au franchissement de l'interface entre petit gap (couches **18** et **14**) et grand gap (couche **16**), même en présence de couches N+ dans la couche intermédiaire **16,** et donc a fortiori en présence de couches N-. Si nécessaire, il est possible de varier la composition de la couche barrière **16** vers les grands gaps, pour en augmenter le caractère isolant.
De plus, il est également possible de varier l'épaisseur de la couche intermédiaire **16** pour limiter le gradient de tension dans celle-ci, l'épaisseur étant choisie en fonction de la différence de polarisation appliquée entre les zones N des couches supérieure et inférieure lors de l'utilisation du détecteur. Une isolation suffisante entre les couches supérieure et inférieure est ainsi réalisée.
A titre d'exemple :
▪ la couche inférieure **14** a une épaisseur de 5 micromètres et une composition en cadmium *x₁₄* de 0,3. La couche **14** est ainsi réglée sur la longueur d'onde 5,5 micromètres pour une température de 77K, et présente un gap Eg = 0, 24 eV ;
▪ la couche supérieure **18** a une épaisseur de 3 micromètres et une composition en cadmium *x₁₈* de 0,22. La couche **18** est ainsi réglée sur la longueur d'onde 11 micromètres pour une température de 77K et présente un gap Eg = 0,1 eV ; et
▪ la couche intermédiaire **16** a une épaisseur de 1 micromètre et une composition en cadmium *x₁₆* de 0,8. La couche **16** présente ainsi un gap Eg = 1,1 eV.

Comme dit plus haut, le mode de réalisation permet une optimisation du taux de remplissage des photodiodes créées par l'implantation ionique. Toutefois une dégradation des performances peut être observée car les zones N dans la couche supérieure **18** comprennent des parties verticales formées des flancs des évidements **22.** Des zones de pincement dans les jonctions PN de la couche supérieure **18** peuvent donc survenir, notamment aux endroits où la zone **44** forme un coude. Or, un pincement dans une jonction PN a pour effet d'augmenter les courants de fuite dans celle-ci, notamment par effet tunnel.

Pour pallier ce problème, un détecteur **50** ne faisant pas partie de la présente invention est illustré aux figures 7 et 8, et diffère du mode de réalisation en ce que les zones N **20** de la couche supérieure, sous les reprises de contact **28,** sont distinctes des zones type N **52** formé sur les flancs des évidements **22,** comme cela est illustré aux figures 7 et 8. Les zones N **20** des jonctions PN de la couche supérieures **18** ne comprennent donc pas de zone de pincement.
Le procédé de fabrication du détecteur **50** diffère ainsi du procédé de fabrication du détecteur **40** selon le mode de réalisation par la géométrie du masque utilisé lors de l'implantation ionique, ce masque masquant également une portion de la couche supérieure **18** autour de chaque évidement **22.**

Dans le détecteur 50, le potentiel des zones N, formées sur les flancs des évidements **22** et comprises dans la couche supérieure **18,** est libre de flotter car elles ne sont raccordées à aucun potentiel fixe. Ces zones sont électriquement isolées des zones de la couche inférieure **14** en raison de la fonction barrière réalisée par la couche intermédiaire **16,** comme expliqué plus haut en relation avec le choix des matériaux de la couche intermédiaire du premier mode de réalisation, et ne sont par ailleurs pas connectées aux zones N des jonctions PN de la couche supérieure **18** (qui sont portées à un potentiel pour la collecte des charges).
En l'absence de polarisation appliquée à la zone N sur le flanc des évidements **22,** la jonction PN va naturellement se mettre à son potentiel de circuit ouvert. Cependant, ce potentiel étant libre, la zone de charge d'espace de cette jonction PN est susceptible de fluctuer dans le temps, sous l'effet de fluctuations de divers paramètres (comme par exemple fluctuation du courant de recombinaison liées aux surfaces des évidements **22).** Par la suite, ces fluctuations des zones N sont également susceptibles de moduler le courant collecté par les diodes voisines. De tels battements sont potentiellement générateurs de bruit pour les jonctions PN avoisinantes, principalement celles de la couche supérieure **18.**

Pour pallier ce problème, un détecteur **60** na faisant pas partie de la présent invention comporte des éléments semi-conducteurs de type N **62,** réalisés par exemple par implantation ionique dans la couche supérieure **18,** conjointement à la réalisation des zones N **20** de celle-ci et des zones N **52** sur les flancs des évidements **22.**

Ces éléments **62** ont pour fonction de fixer le potentiel des portions des zones N **52** comprises dans la couche supérieure **18** à une même valeur. Par exemple, et comme illustré à la figure 9, les éléments **62** connectent entre elles les zones N **52** consécutives d'une même colonne de la matrice d'évidement **22,** les zones **52** en bout de colonne étant par ailleurs connectées à un élément métallique **64,** de préférence porté au même potentiel que celui des reprises de contact **32,** et donc des jonctions PN de la couche inférieure **14.**
Là encore, le procédé de fabrication du détecteur **60** diffère du procédé de fabrication des détecteurs **40** et **50** par la géométrie des masques utilisés lors de l'implantation ionique.

Il a été décrit des procédés de fabrication dans lesquels l'implantation ionique est utilisée pour obtenir les zones N+ entourant les parties d'évidement comprises dans la couche supérieure **18.** L'implantation ionique présente l'avantage d'être technologiquement bien maitrisée, notamment en ce qui concerne le vieillissement des diodes ainsi formées.
Toutefois, l'implantation ionique ne permet de contrôler avec précision la géométrique de la zone implantée que dans le plan perpendiculaire à sa direction d'application. De fait, lorsque l'implantation ionique est appliquée perpendiculairement à l'empilement, des zones N peuvent apparaître dans la couche intermédiaire **16** en raison de l'angle que forme le flanc des évidements avec la direction d'application de l'implantation ionique.
Ainsi, comme dit plus haut, il convient des prendre des précautions vis-à-vis du phénomène de diaphonie qui peut apparaître lorsque des zones N traversent la couche intermédiaire **16,** ce qui impose un choix particulier de matériau pour cette couche.

Il serait possible de ne pas appliquer d'implantation ionique sur les portions d'évidements comprises dans la couche intermédiaire **16,** mais cela supposerait d'appliquer de multiples rotations à l'empilement lors de sa fabrication pour avoir une application perpendiculaire de l'implantation ionique sur les flancs des évidements **22.** Ceci s' avèrerait très couteux en termes de temps de fabrication et de matériel employé.

Pour pallier ce problème, un usinage ionique peut être utilisé, dans une alternative ne faisant pas partie de la présente invention. Cette technique permet d'obtenir le même résultat que l'implantation ionique, à savoir l'inversion de conductivité par dopage tout en formant des zones N constituées de couches N+ et N-.

L'usinage ionique nécessite plus d'étapes de fabrication que la simple implantation ionique sans rotation. En effet, pour doper convenablement les flancs des évidements **22,** il est nécessaire de travailler avec un angle d'incidence du flux ionique non nul (typiquement 30°) accompagné par une rotation continue de l'échantillon lors de l'implantation. En procédant de la sorte, l'inversion de dopage se produit sur une épaisseur de matériau suffisante pour obtenir la fonction de passivation recherchée.

Par contre, dans le cas de la gravure ionique du matériau CdHgTe, l'inversion de dopage se produit sur une distance de l'ordre du micromètre sous la surface gravée, sans qu'il soit nécessaire d'introduire un angle d'incidence, simplifiant ainsi le procédé.

Par exemple, les évidements **22** sont gravés de manière classique puis une surgravure par usinage ionique de la portion de ceux-ci comprise dans la couche supérieure **18** est réalisée, ce qui a pour effet de créer des zones N uniquement sur cette portion, et donc une couche N+ entourant chaque évidement **22.** En outre, l'usinage ionique a également pour avantage de réaliser une inversion de conductivité sur une plus grande épaisseur que l'implantation ionique, et donc d'obtenir une épaisseur de couche N+ plus importante.

Les zones N **72, 74** des jonctions PN des couches supérieure **18** et inférieure **14,** telles qu'illustrées à la figure 10, sont par exemple également réalisées par usinage ionique, les zones N des jonctions PN de la couche supérieure **18** formant de manière avantageuse, mais non nécessaire, des volumes continus **72** avec les zones N des évidements **22,** pour un taux de remplissage optimal.

Comme il n'existe pas de zones N traversant la couche intermédiaire **16,** il est possible de relâcher les contraintes pesant sur le choix des matériaux constitutifs de celle-ci.

A titre d'exemple numérique :
▪ les évidements sont séparées d'une distance de 20 micromètres;
▪ les évidements sont cylindriques et d'un diamètre de 8 micromètres;
▪ au moins une zone N d'un diamètre de 10 micromètre est formée autour de chaque évidement ;
▪ des zones N de 4 micromètres sont formées au fond des évidements; et
▪ des zones N d'un diamètre compris entre 4 micromètres et 6 micromètres sont formées sur la couche supérieure.

Il a été décrit une application de l'invention dans le cadre d'alliage CdₓHg₁₋ₓTe.

Bien entendu, l'invention peut s'appliquer à d'autres types de matériau avec le même résultat, à savoir la formation d'une couche N+ de concentration en dopant de type N et d'épaisseur suffisante pour masquer électriquement les évidements.
Par exemple, les matériaux petit gap à base de sels de plomb (par exemple l'alliage PbSnTe) présentent la même souplesse de conception d'hétéro-structures que le matériau CdHgTe. Les structures bispectrales présentées ici pourraient être réalisées par implantation ionique d'Antimoine, ou encore en utilisant diffusion de Cadmium pour former une zone N autour d'un trou entre deux couches de PbSnTe dopés P de compositions différentes séparées par une couche de SiO2 faisant office de barrière.
De même l'invention s'applique également à la formation de couches P+ dans des matériaux de type N. On observe que les mêmes conditions sur la concentration et l'épaisseur décrite plus haut s'appliquent.
Enfin, il a été décrit des procédés de fabrication préférentiels utilisant l'implantation ou l'usinage ionique.
Une couche N+, ou P+, selon l'invention peut également être obtenue par la diffusion d'une impureté à travers une ouverture résine ou passivation, par exemple la diffusion de Cadmium dans le matériau PbSnTe comme cité précédemment. La couche intermédiaire formant barrière est réalisée en un matériau isolant ou en un matériau semi-conducteur dont la bande interdite est au moins trois fois supérieure à la bande interdite de la couche semi-conductrice supérieure d'absorption et au moins trois fois supérieure à la bande interdite de la couche semi-conductrice inférieure d'absorption.

## Revendications

1. Détecteur bispectral d'une première et seconde gammes de rayonnements électromagnétiques, comportant :
▪ un empilement de couches semi-conductrices supérieure (18) et inférieure (14) d'un premier type de conductivité pour l'absorption des première et seconde gammes de rayonnements électromagnétiques respectivement, séparées par une couche intermédiaire (16) formant barrière de potentiel entre les couches supérieure (18) et inférieure (14) ;
▪ des zones semi-conductrices (44 ; 20) d'un second type de conductivité opposé au premier type, implantées dans les couches supérieure (18) et inférieure (14), chaque zone semi-conductrice (44) dans la couche inférieure (14) étant implantée au moins partiellement dans le fond d'un évidement (22) traversant les couches supérieure (18) et intermédiaire (16); et
▪ des éléments conducteurs d'électricité (28, 30, 32, 34) connectés respectivement aux zones semi-conductrices (44; 20) pour la collecte de charges électriques dans celles-ci,
***caractérisé* :**
▪ en ce qu'au moins la partie de chaque évidement (22) traversant la couche supérieure (18) est séparée de cette dernière par une couche écran (46) semi-conductrice du second type de conductivité :
o dont la concentration en dopants du second type de conductivité est supérieure à 10¹⁷ cm⁻³; et
o dont l'épaisseur est choisie en fonction de ladite concentration de manière à être supérieure à la longueur de diffusion des porteurs minoritaires dans la couche écran ;
▪ en ce que chaque zone semi-conductrice du second type de conductivité de la couche supérieure (18) forme avec une zone semi-conductrice adjacente du second type de conductivité de la couche inférieure (14) un volume continu (44);
▪ et en ce que la couche intermédiaire (16) est réalisée en un matériau isolant relativement aux matériaux des couches supérieure et inférieure, ou en un matériau semi-conducteur du premier type de conductivité dont la bande interdite est supérieure à trois fois celle de chacune des couches supérieure (18) et inférieure (14).

2. Détecteur bispectral selon la revendication 1, ***caractérisé* :**
▪ en ce que les couches supérieure (18) et inférieure (14) sont réalisées en un alliage de cadmium, de mercure et de tellure, dopées P par lacunes de mercure ;
▪ et en ce que la couche intermédiaire (16) est réalisée en un alliage de cadmium et de tellure ou en un alliage de cadmium, de zinc et de tellure.

3. Détecteur bispectral selon la revendication 1, ***caractérisé* :**
▪ en ce que les couches supérieure (18) et inférieure (14) sont réalisées en un alliage de cadmium, de mercure et de tellure, dopées P par lacunes de mercure ;
▪ et en ce que la couche intermédiaire (16) est réalisée un alliage de cadmium, de mercure et de tellure, dont la composition en mercure est inférieure à la moitié de la composition en mercure dans chacune des couches supérieure et inférieure.

4. Détecteur bispectral selon l'une quelconque des revendications précédentes, ***caractérisé* en ce que** la partie de chaque évidement traversant la couche intermédiaire est séparée de cette dernière par une couche écran semi-conductrice du second type de conductivité.

5. Procédé de réalisation d'un détecteur bispectral d'une première et seconde gammes de rayonnements électromagnétique selon la revendication 1, consistant :
▪ à former un empilement de couches semi-conductrices supérieure (18) et inférieure (14) d'un premier type de conductivité pour l'absorption des première et seconde gammes de rayonnements électromagnétiques respectivement, séparées par une couche intermédiaire (16) formant barrière de potentiel entre les couches supérieure (18) et inférieure (14);
▪ à réaliser au moins un évidement (22) au travers des couches supérieure (18) et inférieure (14), s'étendant jusqu'à la couche inférieure (14);
▪ à réaliser un premier et un second ensembles de zones semi-conductrices (44; 20) d'un second type de conductivité opposé au premier type, implantés dans les couches supérieure (18) et inférieure (14) respectivement, une zone semi-conductrice (44) étant implantée au moins partiellement dans le fond de chaque évidement (22) ; et
▪ à réaliser des éléments conducteurs d'électricité (28, 30, 32, 34), connectés respectivement aux zones semi-conductrices (44 ; 20) pour la collecte de charges électriques dans celles-ci,
***caractérisé*** :
▪ en ce que chaque zone semi-conductrice de la couche supérieure (18) forme avec une zone semi-conductrice adjacente de la couche inférieure (14) un volume continu (44);
▪ en ce que la couche intermédiaire (16) est réalisée en un matériau isolant relativement aux matériaux des couches supérieure et inférieure, ou en un matériau semi-conducteur du premier type de conductivité dont la bande interdite est supérieure à trois fois celle de chacune des couches supérieure (18) et inférieure (14);
▪ et en ce qu'un dopage du second type de conductivité par implantation ionique ou usinage ionique est réalisé sur les flancs de chaque évidement (22), au moins sur la partie desdits flancs agencée dans la couche supérieure (18).

6. Procédé de réalisation d'un détecteur bispectral selon la revendication 5, ***caractérisé*:**
▪ en ce que la couche intermédiaire (16) est réalisée en un matériau isolant relativement aux matériaux des couches supérieure (18) et inférieure (14), ou en un matériau semi-conducteur du premier type de conductivité dont la bande interdite est choisie trois fois supérieure à celle de chacune des couches supérieure (18) et inférieure (14) ;
▪ et en ce que le dopage du second type de conductivité est appliqué sur la totalité des évidements (22), de sorte que, dans le fond de ceux-ci, les zones semi-conductrices (44) de second type de conductivité sont formées dans la couche inférieure (14).

7. Procédé de réalisation d'un détecteur bispectral selon l'une des revendications 5 et 6, ***caractérisé* en ce que** le dopage du second type de conductivité sur les flancs des évidements est réalisé par un usinage ionique uniquement pour la portion des flancs des évidements (22) comprise dans la couche supérieure (18).

8. Procédé de réalisation d'un détecteur bispectral selon l'une des revendications 6 et 7, ***caractérisé* en ce que** le dopage du second type de conductivité sur les flancs des évidements se prolonge sur la face libre (42) de la couche supérieure (18), de sorte que les zones semi-conductrices (44) du second type de conductivité sont formées dans celle-ci.

9. Procédé de réalisation d'un détecteur bispectral selon l'une des revendications 6 et 7, ***caractérisé* en ce que** les zones semi-conductrices de second type de conductivité (20) dans la couche supérieure (18) sont réalisées de manière à ne pas être en contact avec les zones semi-conductrices du second type (52) obtenues à l'issue du dopage des flancs des évidements.

10. Procédé de réalisation d'un détecteur bispectral selon la revendication 9, ***caractérisé* en ce qu'**il est en outre formé, dans la couche supérieure (18), des éléments semi-conducteurs du second type (62), notamment par implantation ionique ou usinage ionique, raccordant des zones semi-conductrices du second type obtenues à l'issue du dopage des flancs des évidements (22) à un élément conducteur commun (64).

11. Procédé de réalisation d'un détecteur bispectral selon l'une quelconque des revendications 5 à 10 ***caractérisé**:*
▪ en ce que les couches supérieure (18) et inférieure (14) sont réalisées en un alliage de cadmium, de mercure et de tellure, dopées P par lacunes de mercure;
▪ et en ce que la couche intermédiaire (16) est réalisée en un alliage de cadmium et de tellure ou en un alliage de cadmium, de zinc et de tellure.

12. Procédé de réalisation d'un détecteur bispectral selon l'une quelconque des revendications 5 à 10, ***caractérisé** :*
▪ en ce que les couches supérieure (18) et inférieure (14) sont réalisées en un alliage de cadmium, de mercure et de tellure, dopées P par lacunes de mercure ;
▪ et en ce que la couche intermédiaire (16) est réalisée un alliage de cadmium, de mercure et de tellure, dont la composition en mercure est inférieure à la moitié de la composition en mercure dans chacune des couches supérieure et inférieure.

## Patentansprüche

1. Bi- spektraler Detektor für einen ersten und zweite Bereich elektromagnetischer Strahlung, umfassend:
▪ einen Stapel, der eine obere Halbleiterschicht (18) und eine untere Halbleiterschicht (14) mit einem ersten Leitfähigkeitstyp enthält, zur Absorption des ersten bzw. zweiten Bereichs elektromagnetischer Strahlung, unterteilt durch eine Zwischenschicht (16), die eine Potentialbarriere zwischen der oberen Schicht (18) und der unteren Schicht (14) bildet;
▪ Halbleiterbereiche (44; 20) mit einem zweiten Leitfähigkeitstyp, entgegengesetzt zum ersten Typ, eingesetzt in der oberen (18) und unteren (14) Schicht, jeder Halbleiterbereich (44) in der unteren (14) Schicht ist zumindest teilweise in den Boden einer Aussparung (22) eingesetzt, die die obere Schicht (18) und die Zwischenschicht (16) durchquert; und
▪ elektrizitätsleitende Elemente (28, 30, 32, 34) jeweils verbunden mit den Halbleiterbereichen (44; 20) zum Sammeln der darin enthaltenen elektrischen Ladungen,
***dadurch gekennzeichnet dass*:**
▪ mindestens der Teil jeder Aussparung (22), der die obere Schicht (18) durchquert, von dieser durch eine Halbleiter- Schutzschicht (46) vom zweiten Leitfähigkeitstyp getrennt ist.
∘ deren Konzentration an Dotierstoffen des zweiten Leitfähigkeitstyps über 10¹⁷ cm⁻³ liegt; und
∘ deren Dicke ausgewählt wird entsprechend dieser Konzentration, so dass sie höher ist als die Diffusionslänge der Minoritätsladungsträger in der Sperrschicht;
▪ dass jede Halbleiterzone des zweiten Leitfähigkeitstyps der oberen Schicht (18) mit einer benachbarten Halbleiterzone des zweiten Leitfähigkeitstyps der unteren Schicht (14) ein durchgehendes Volumen bildet (44);
▪ und dass die Zwischenschicht (16) aus einem gegenüber den oberen und unteren Schichten isolierenden Material oder aus einem Halbleitermaterial des ersten Leitfähigkeitstyps ausgeführt ist, bei dem der Bandabstand größer ist als das Dreifache jeweils der oberen (18) und unteren (14) Schicht.

2. Bi- spektraler Detektor gemäß Anspruch 1 ***gekennzeichnet dadurch, dass:***
▪ die obere (18) und untere (14) Schicht aus einer Cadmium-, Quecksilber- und Tellur- Legierung ausgeführt sind, P-dotiert durch Quecksilberlücken;
▪ und dass die Zwischenschicht (16) aus einer Cadmium- Tellur - Legierung oder einer Cadmium-, Zink- und Tellur- Legierung ausgeführt ist.

3. Bi- spektraler Detektor gemäß Anspruch 1 ***gekennzeichnet dadurch, dass:***
▪ die obere (18) und untere (14) Schicht aus einer Cadmium-, Quecksilber- und Tellur- Legierung ausgeführt sind, P-dotiert durch Quecksilberlücken;
▪ und dass die Zwischenschicht (16) aus einer Cadmium- Quecksilber- Tellur - Legierung ausgeführt ist, bei dem die Quecksilber- Zusammensetzung niedriger ist als die Hälfte der Quecksilber- Zusammensetzung in jeder der oberen und unteren Schichten.

4. Bi- spektraler Detektor gemäß einem der vorhergehenden Ansprüche, ***gekennzeichnet dadurch, dass*** der Teil jeder Aussparung der Zwischenschicht durchquert von dieser durch eine Halbleiter- Schutzschicht vom zweiten Leitfähigkeitstyp getrennt ist.

5. Verfahren zur Herstellung eines bi- spektralen Detektors für einen ersten und zweiten Bereich elektromagnetischer Strahlung gemäß Anspruch 1, das darin besteht:
▪ Bildung eines Stapels mit einer oberen Halbleiterschicht (18) und einer unteren Halbleiterschicht (14) mit einem ersten Leitfähigkeitstyp, zur Absorption des ersten bzw. zweiten Bereichs elektromagnetischer Strahlung, unterteilt durch eine Zwischenschicht (16), die eine Potentialbarriere zwischen der oberen Schicht (18) und der unteren Schicht (14) bildet;
▪ Ausführung mindestens einer Aussparung (22) durch die obere (18) und untere Schicht (14), die bis zur unteren Schicht (14) reicht;
▪ Ausführung einer ersten und zweiten Einheit von Halbleiterbereichen (44; 20) mit einem zweiten Leitfähigkeitstyp, entgegengesetzt zum ersten Typ, eingesetzt jeweils in der oberen (18) und unteren (14) Schicht, ein Halbleiterbereich (44) ist zumindest teilweise in den Boden jeder Aussparung (22) eingesetzt; und
▪ Ausführung von elektrizitätsleitenden Elementen (28, 30, 32, 34) jeweils verbunden mit den Halbleiterbereichen (44; 20) zum Sammeln der darin enthaltenen elektrischen Ladungen,
***gekennzeichnet dadurch, dass***
▪ jede Halbleiterzone der oberen Schicht (18) mit einer benachbarten Halbleiterzone der unteren Schicht (14) ein durchgehendes Volumen bildet (44);
▪ und dass die Zwischenschicht (16) aus einem gegenüber den oberen und unteren Schichten isolierenden Material oder aus einem Halbleitermaterial des ersten Leitfähigkeitstyps besteht, bei dem der Bandabstand größer ist als das Dreifache jeweils der oberen (18) und unteren (14) Schicht.
▪ und dadurch dass eine Dotierung vom zweiten Leitfähigkeitstyp durch Ionenimplantation oder Ionenbearbeitung auf den Seiten jeder Aussparung (22) ausgeführt wird, mindestens an dem Teil dieser Seiten, der in der oberen (18) Schicht vorgesehen ist.

6. Verfahren zur Herstellung eines bi- spektralen Detektors gemäß Anspruch 5 ***gekennzeichnet dadurch, dass:***
▪ die Zwischenschicht (16) aus einem gegenüber der oberen (18) und unteren (14) Schicht isolierenden Material oder aus einem Halbleitermaterial des ersten Leitfähigkeitstyps ausgeführt ist, bei dem der Bandabstand drei Mal größer gewählt wird, als der jeweils der oberen (18) und unteren (14) Schicht;
▪ und dass die Dotierung des zweiten Leitfähigkeitstyps auf alle Aussparungen (22) angewandt wird, so dass auf deren Boden die Halbleiterzonen (44) des zweiten Leitfähigkeitstyps, in der unteren Schicht (14) gebildet werden.

7. Verfahren zur Herstellung eines bi- spektralen Detektors gemäß einem der Ansprüche 5 und 6, ***gekennzeichnet dadurch, dass*** die Dotierung des zweiten Leitfähigkeitstyps an den Seiten der Aussparungen durch Ionenbearbeitung nur für das Teilstück der Seiten der Aussparungen (22) ausgeführt wird, das sich in der oberen Schicht (18) befindet.

8. Verfahren zur Herstellung eines bi- spektralen Detektors gemäß einem der Ansprüche 6 und 7, ***gekennzeichnet dadurch, dass*** die Dotierung des zweiten Leitfähigkeitstyps an den Seiten der Aussparungen sich über die freie Seite (42) der oberen Schicht (18) verlängern, so dass die Halbleiterzonen (44) des zweiten Leitfähigkeitstyps in dieser gebildet werden.

9. Verfahren zur Herstellung eines bi- spektralen Detektors gemäß Anspruch 6 und 7, ***gekennzeichnet dadurch, dass*** die Halbleiterzonen des zweiten Leitfähigkeitstyps (20) in der oberen Schicht (18) so ausgeführt werden, dass sie keinen Kontakt zu den Halbleiterzonen des zweiten Leitfähigkeitstyps (52) haben, die sich nach der Dotierung der Aussparungsseiten ergeben.

10. Verfahren zur Herstellung eines bi- spektralen Detektors gemäß Anspruch 9, ***gekennzeichnet dadurch, dass*** außerdem in der oberen Schicht (18) Halbleiterelemente des zweiten Leitfähigkeitstyps (62) gebildet werden, insbesondere durch Ionenimplantation oder Ionenbearbeitung, die die Halbleiterzonen des zweiten Leitfähigkeitstyps, die sich nach der Dotierung der Aussparungsseiten (22) ergeben, mit einem gemeinsamen leitenden Element (64) verbinden.

11. Verfahren zur Herstellung eines bi- spektralen Detektors gemäß Anspruch 5 bis 10, ***gekennzeichnet dadurch, dass:***
▪ die obere (18) und untere (14) Schicht aus einer Cadmium-, Quecksilber- und Tellur- Legierung ausgeführt sind, P-dotiert durch Quecksilberlücken;
▪ und dass die Zwischenschicht (16) aus einer Cadmium- Tellur - Legierung oder einer Cadmium-, Zink- und Tellur- Legierung ausgeführt ist.

12. Verfahren zur Herstellung eines bi- spektralen Detektors gemäß Anspruch 5 bis 10, ***gekennzeichnet dadurch, dass:***
▪ die obere (18) und untere (14) Schicht aus einer Cadmium-, Quecksilber- und Tellur- Legierung ausgeführt sind, P-dotiert durch Quecksilberlücken;
▪ und dass die Zwischenschicht (16) aus einer Cadmium- Quecksilber- Tellur - Legierung ausgeführt ist, bei dem die Quecksilber- Zusammensetzung niedriger ist als die Hälfte der Quecksilber- Zusammensetzung in sowohl der oberen wie der unteren Schicht.

## Claims

1. A bispectral detector for detecting a first and a second electromagnetic radiation ranges, comprising:
- a stack of upper (18) and lower (14) semiconductor layers of a first conductivity type in order to absorb a first and a second electromagnetic radiation ranges respectively, separated by an intermediate layer (16) that forms a potential barrier between the upper (18) and lower (14) layers;
- semiconductor zones (44; 20) of a second conductivity type opposite to the first conductivity type and implanted in the upper layer (18) and lower layer (14), each semiconductor zone (44) in the lower layer (14) being implanted at least partially in the bottom of an opening (22) that passes through the upper layer (18) and intermediate layer (16); and
- electrical conductor elements (28, 30, 32, 34) connected respectively to semiconductor zones (44; 20) in order to collect the electrical charges in these zones ;
***characterised* :**
- **in that** at least that part of each opening (22) that passes through upper layer (18) is separated from said upper layer (18) by a semiconductor cap layer (46) of the second conductivity type:
▪ whereof the concentration of dopants of the second conductivity type is greater than 10¹⁷ cm⁻³; and
▪ whereof the thickness is chosen as a function of said concentration so that it exceeds the minority carrier diffusion length in the cap layer ;
- **in that** every semiconductor zone of the second conductivity type :in the upper layer (18) forms with an adjacent semiconductor zone of the second conductivity type :of the lower layer (14) a continuous volume (44);
- and **in that** the intermediate layer (16) is made of a material that is insulating with respect to the materials of the upper and lower layers or is made of a semiconductor material of the first conductivity type, whereof the band gap is more than three times that of each of the upper layer (18) and lower layer (14).

2. The bispectral detector as claimed in claim 1, ***characterised***
▪ in that the upper layer (18) and the lower layer (14) are made of an alloy of cadmium, mercury and tellurium that is P-doped by mercury vacancies;
▪ and in that the intermediate layer (16) is made of an alloy of cadmium and tellurium or an alloy of cadmium, zinc and tellurium.

3. The bispectral detector as claimed in claim, ***characterised:***
▪ in that the upper layer (18) and the lower layer (14) are made of an alloy of cadmium, mercury and tellurium that is P-doped by mercury vacancies;
▪ and in that the intermediate layer (16) is made of an alloy of cadmium, mercury and tellurium having a mercury composition that is less than half of the mercury composition of each of the upper and lower layers.

4. The bispectral detector as claimed in any of the above claims, ***characterised* in that** the part of each opening that passes through the intermediate layer is separated from the latter by a semiconductor cap layer of the second conductivity type.

5. A method for manufacturing a bispectral detector for detecting a first and a second electromagnetic radiation ranges according to claim 1, involving:
▪ forming a stack of upper (18) and lower (14) semiconductor layers of a first conductivity type in order to absorb a first and a second electromagnetic radiation ranges respectively, separated by an intermediate layer (16) that forms a potential barrier between the upper layer (18) and the lower layer (14);
▪ producing at least one opening (22) through the upper layer (18) and lower (14) layer and extending as far as the lower layer (14);
▪ producing a first and a second set of semiconductor zones (44; 20) of a second conductivity type opposite to the first conductivity type and implanted in the upper layer (18) and the lower layer (14) respectively, one semiconductor zone (44) being implanted at least partially in the bottom of each opening (22); and
▪ producing electrical conductor elements (28, 30, 32, 34) connected respectively to semiconductor zones (44; 20) in order to collect the electrical charges in these zones,
***characterised* :**
- **in that** every semiconductor zone of the upper layer (18) forms with an adjacent semiconductor zone :of the lower layer (14) a continuous volume (44);
- **in that** the intermediate layer (16) is made of a material that is insulating with respect to the materials of the upper and lower layers or is made of a semiconductor material of the first conductivity type, whereof the band gap is more than three times that of each of the upper layer (18) and lower layer (14),
- **in that** doping of the second conductivity type by ion implantation or ion beam milling is performed on the flanks of every opening (22) at least on that part of said flanks that is located in the upper layer (18).

6. The method for manufacturing a bispectral detector according to claim 5, ***characterised* :**
▪ in that the intermediate layer (16) is made of a material that is insulating with respect to the materials of the upper layer (18) and the lower layer (14) or is made of a semiconductor material of the first conductivity type, whereof the band gap is more than three times that of each of the upper layer (18) and lower layer (14);
▪ and in that doping of the second conductivity type is applied to all the openings (22) so that, in the bottom of said openings, semiconductor zones (44) of a second conductivity type are formed in the lower layer (14).

7. The method for manufacturing a bispectral detector as claimed in either claim 5 or *6,* ***characterised* in that** doping of the second conductivity type on the flanks of the openings is performed by ion beam milling only for that portion of the flanks of openings (22) contained in upper layer (18).

8. The method for manufacturing a bispectral detector as claimed in either claim 6 or *7,* ***characterised* in that** doping of the second conductivity type on the flanks of the openings extends onto the exposed face (42) of the upper layer (18), so that semiconductor zones (44) of the second conductivity type are formed in the upper layer.

9. The method for manufacturing a bispectral detector as claimed in either claim 6 or *7,* ***characterised* in that** semiconductor zones of the second conductivity type (20) in the upper layer (18) are produced so that they are not in contact with the semiconductor zones of the second conductivity type (52) obtained after doping the flanks of the openings.

10. The method for manufacturing a bispectral detector as claimed in claim 9, ***characterised* in that** semiconductor elements of the second conductivity type (62) are also formed in the upper layer (18), especially by ion implantation or ion beam milling and these elements connect the semiconductor zones of the second conductivity type obtained after doping the flanks of the openings (22) to a common conductor element (64).

11. The method for manufacturing a bispectral detector as claimed in any of claims 5 to 10, ***characterised:***
▪ in that the upper layer (18) and the lower layer (14) are made of an alloy of cadmium, mercury and tellurium that is P-doped by mercury vacancies;
▪ and in that the intermediate layer (16) is made of an alloy of cadmium and tellurium or an alloy of cadmium, zinc and tellurium.

12. The method for manufacturing a bispectral detector as claimed in any of claims 5 to 10, ***characterised:***
▪ in that the upper layer (18) and the lower layer (14) are made of an alloy of cadmium, mercury and tellurium that is P-doped by mercury vacancies;
▪ and in that the intermediate layer (16) is made of an alloy of cadmium, mercury and tellurium having a mercury composition that is less than half of the mercury composition of each of the upper and lower layers.
